# EUROPEAN PATENT SPECIFICATION

(11) **EP 4 428 917 B1**
(45) Date of publication and mention of the grant of the patent: **24.12.2025**
(21) Application number: 24162631.6
(22) Date of filing: 11.03.2024
(51) Int. Cl.: H01L 23/498, H01L 23/15, H01L 23/48, H01L 23/00, H01L 23/055, H01L 23/367, H01L 23/24, H01L 23/373

(54) **METAL-CERAMIC MIXED PACKAGE SUBSTRATE PLATED WITH NONMAGNETIC LAYER STACK**
MIT NICHTMAGNETISCHEM SCHICHTSTAPEL PLATTIERTES METALL-KERAMIK-MISCHPAKETSUBSTRAT
SUBSTRAT D'EMBALLAGE MIXTE MÉTAL-CÉRAMIQUE PLAQUÉ PAR EMPILEMENT DE COUCHES NON MAGNÉTIQUES

(30) Priority: 10.03.2023 US 202363489559 P
(43) Date of publication of application: 11.09.2024
(73) Proprietor: Advanced Technical Ceramics Company, Chattanooga, TN 37405 (US)
(72) Inventor: FITZSIMMONS, Aaron, Chattanooga, TN 37405 (US); MINEHAN, William T., Chattanooga, TN 37405 (US); CUSHING, David A., Chattanooga, TN 37405 (US); JONES, Kera, Chattanooga, TN 37405 (US)
(74) Representative: Barker Brettell LLP

(56) References cited:
- JP-A- 2015 185 820
- US-A- 4 941 582
- US-A1- 2005 218 506
- US-A1- 2012 177 853
- US-A1- 2014 009 875
- US-A1- 2017 148 718

## Description

### BACKGROUND

### Field

The disclosed technology generally relates to co-fired substrates, and more particularly to co-fired substrates having non-magnetic metal layers plated thereon.

### Description of the Related Art

Packages for integrated circuit (IC) devices physically and electrically connect the IC devices to their interfaces to the outside world, e.g., printed circuit boards (PCBs). As electronic devices continue to shrink in size, incorporate multiple functionalities and/or find specialized applications, the demand for higher electrical and thermal performance of the packaging technology for many components and modules of the electronic devices, including the integrated circuit (IC) devices, continues to increase.

### SUMMARY

In one aspect, a ceramic package configured to house an electronic device, the ceramic package includes a ceramic substrate and a non-magnetic metallization stack formed on the ceramic substrate. The non-magnetic metallization stack includes a base metal layer formed on the ceramic substrate, a palladium (Pd)-based layer formed on the base metal layer, and a gold (Au)-based layer formed on the Pd-based layer. The non-magnetic metallization stack does not include a magnetic metal layer.

In another aspect, a ceramic package configured to house an electronic device includes a ceramic substrate integrated with a non-magnetic metallization stack. The non-magnetic metallization stack includes a base metal layer formed on the ceramic substrate, a noble metal-containing layer formed over the base metal layer, and a gold (Au)-based layer formed over the noble metal-containing layer. At least a portion of the non-magnetic metallization stack is embedded in the ceramic substrate.

In another aspect, a ceramic package configured to house an electronic device includes a co-fired substrate including a ceramic substrate co-fired with a base metal layer thereover. The ceramic package further includes a palladium (Pd)-based layer formed on the base metal layer and a gold (Au)-based layer formed on the Pd-based layer. The ceramic package does not include a magnetic metal layer between the co-fired substrate and the Au-based layer.

In another aspect, a ceramic package includes a co-fired substrate formed from a ceramic substrate co-fired with a base metal layer. The ceramic package further includes a non-magnetic metallic layer formed on the base metal layer and a gold (Au)-based layer formed on the non-magnetic metallic layer. The ceramic package does not include a magnetic metal between the Au-based layer and the co-fired substrate.

In another aspect, a method of forming a ceramic package configured to house an electronic device includes providing a ceramic substrate and forming a non-magnetic metallization stack on the ceramic substrate. Forming the non-magnetic metallization stack on the ceramic substrate includes forming a base metal layer on the ceramic substrate, depositing a palladium-based layer on the base metal layer, and forming a gold-based layer on the palladium-based layer, wherein the non-magnetic metallization stack does not include a magnetic metal layer.

In another aspect, a method of forming a ceramic package configured to house an electronic device includes providing a ceramic substrate and forming a non-magnetic metallization stack on the ceramic substrate. Forming the non-magnetic metallization stack on the ceramic substrate comprises depositing a base metal layer on the ceramic substrate, co-firing the ceramic substrate and base metal layer to form a co-fired substrate, depositing a noble metal-containing layer on the co-fired substrate, and depositing a gold-based layer on the noble metal-containing layer. The ceramic package does not include a magnetic metal layer between the gold-based layer and the co-fired substrate.

In another aspect, a method of forming a ceramic package configured to house an electronic device includes forming a ceramic powder into a ceramic substrate, depositing a non-magnetic base metal layer over the ceramic substrate, co-firing the ceramic substrate and base metal layer to form a co-fired substrate, forming a non-magnetic metallic layer on the co-fired substrate, and forming a gold-based layer on the non-magnetic metallic layer. The ceramic package does not include a magnetic metal layer between the gold-based layer and the co-fired substrate.

### BRIEF DESCRIPTION OF THE DRAWINGS

Figure 1A illustrates a ceramic package housing therein an electronic component (e.g., an IC die), where the ceramic package includes metallization structures formed by a selective deposition process, according to some embodiments.
Figure 1B illustrates a ceramic package housing therein an electronic component (e.g., an IC die), where the ceramic package includes a plurality of levels of metallization structures formed by a selective deposition process, according to some other embodiments.
Figure 1C illustrates a portion of the ceramic packages illustrated in Figures 1A and 1B, where the portion includes thermally/electrically conducting structures that provide thermal/electrical communication between the IC die and an interface to the outside world, according to some embodiments.
Figure 1D illustrates a portion of the ceramic packages illustrated in Figures 1A and 1B, where the portion includes thermally/electrically conducting structures that provide thermal/electrical communication between the IC die and an interface to the outside world, according to some other embodiments.
Figure 1E illustrates a portion of the ceramic packages illustrated in Figures 1A and 1B, where the portion includes thermally/electrically conducting structures that provide thermal/electrical communication between the IC die and an interface to the outside world, according to some other embodiments.
Figure 2 illustrates a method of fabricating ceramic packages including selectively metallizing, according to embodiments.
Figures 3A-3D illustrate intermediate structures at various stages of fabricating a ceramic package, including selectively metallizing according to embodiments.
Figure 4 illustrates a ceramic package housing therein an IC die, where the ceramic package includes a plurality of different metallization structures that provide thermal/electrical communication between the IC die and an interface to the outside world.

### DETAILED DESCRIPTION

The disclosed technology relates to metalizing substrates, e.g., packages for various active and passive electronic components, such as integrated circuit (IC) devices, piezoelectric devices, photonic devices and sensors such as image sensors, to name a few. Various integrated circuit (IC) devices are physically and electrically connected the outside world through packages. The packages provide an electrical connection for the IC devices to the outside world through an interface, e.g., printed circuit board (PCB). As electronic devices continue to shrink in size, incorporate multiple functionalities and/or find specialized applications, the demand for higher electrical and thermal performance of the packaging technology for many components and modules of the electronic devices, including the integrated circuit (IC) devices, continues to increase. see for example document JP 2015 185820 A. For example, for some very high reliability packages, it may be desirable to use a high temperature co-fired ceramic (HTCC) process, with the aim of achieving a plating process and a sealing between a lid and ceramic enclosure that produce very low outgassing, nearly void-free solder joint and a hermetic sea see for example documents US 2012/177853 A1 and US 2005/218506 A1. Hermetically sealed IC packages formed using HTCC processes have the potential to be especially useful for certain applications in which magnetic materials are omitted, e.g., medical devices and sensors implanted in humans. Some of the more common magnetic materials include iron, cobalt and nickel. However, existing packaging for IC devices include at least one layer of magnetic layer such as nickel, which may not be suitable for certain IC devices and applications. Ni is often used, e.g., to serve as a diffusion barrier between gold and copper. However, nickel is magnetic and packaging having magnetic metallization layers can interfere with circuitry and performance of some IC devices. Additionally, nickel can be toxic to humans, which means that packaging having metallization layers that include nickel are not biocompatible and therefore cannot be used in medical device applications. Thus, there is an unmet need for high performance and high reliability packaging of IC devices with metallization structures that do not include nickel while still having few electrical shorts, high planarity, improved adhesion, high temperature tolerance, high hermetic sealing performance, and that are biocompatible, to name a few attributes. To address these and other needs, described herein are various embodiments directed to selective metallization of substrates, e.g., ceramic substrates, for IC devices.

### IC Packages Having Selective Metallization Formed on a Base Metal Layer

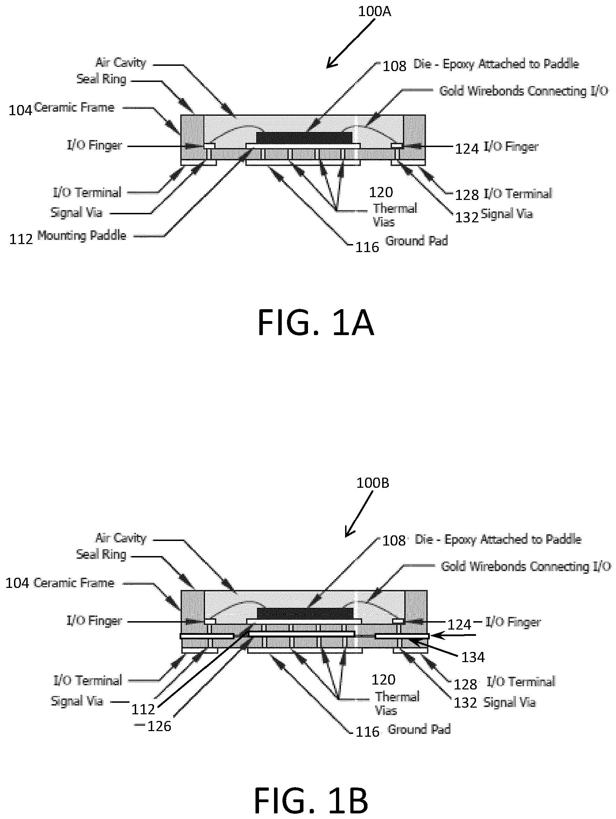

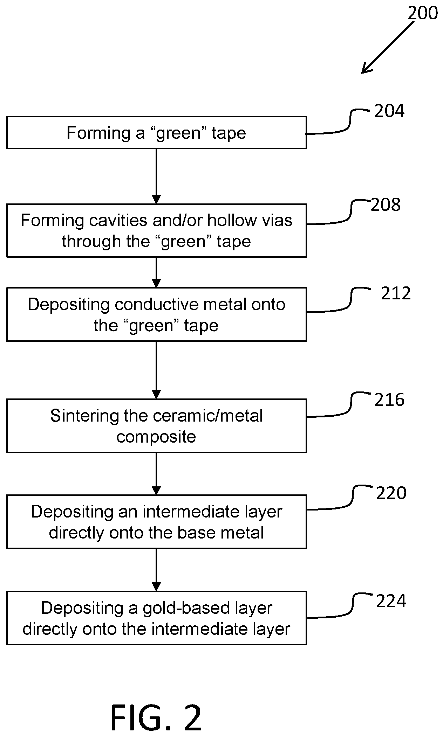

Figure 1A illustrates a ceramic package 100A housing therein an electronic component, where the ceramic package includes metallization structures formed by a selective deposition process (Figure 2B), according to some embodiments. In the illustrated embodiment, the electronic component is IC die 108. In other embodiments, the electronic component can comprise a different of active or passive electronic component. The ceramic package 100A includes a ceramic substrate 104, or a ceramic frame, configured to house the IC die 108 therein and to provide thermal and electrical communication between the IC die 108 and the outside world. The ceramic package 100 is configured to provide thermal communication between the IC die 108 and an interface to the outside world, e.g., a PCB (not shown), through one or more metallization structures. The one or more metallization structures configured to provide the thermal communication include one or more of an inner thermal pad 112, an outer thermal pad 116 and one or more thermal vias 120. The inner thermal pad 112, e.g., a mounting pad or paddle, may be physically attached and configured to be in thermal communication with, e.g., to carry heat away from, the IC die 108. The outer thermal pad 116, e.g., a ground pad 116, is configured to be in thermal communication with, e.g., transfer heat to, an interface to the outside world, e.g., a PCB. The one or more vias 120, e.g., thermal vias, thermally connect the inner thermal pad 112 and the outer thermal pad 116 to provide the thermal communication therebetween. The ceramic package 100 is additionally configured to provide electrical communication between the IC die 108 and an interface to the outside world, e.g., a PCB, through one or more metallization structures. The one or more metallization structures configured to provide the electrical communication include one or more of an inner thermal electrical pad 124, an outer electrical pad 128 and one or more electrical vias 132. The inner electrical pad 124, e.g., an I/O finger, is configured to be in electrical communication with the IC die 108, e.g., through a wirebond. The outer electrical pad 128, e.g., an I/O terminal, is configured to be in electrical communication with an interface to the outside world, e.g., a PCB. The one or more vias 132, e.g., electrical vias, electrically connect the inner electrical pad 124 and the outer electrical pad 128 to provide the electrical communication therebetween. As described herein, while certain structures may be described as thermally conducting structures and other structures may be described as electrically conducting structures, it will be appreciated that under some configurations, thermally conducting structures and electrically conducting structures can be configured to serve as one or both electrically conducting structures and thermally conducting structures.

While the ceramic package 100A illustrated with respect Figure 1A is shown as having a single ceramic layer and a single level of metallization structures interposed between the IC die 108 and an interface to the outside world, e.g., a PCB, embodiments are not so limited. Figure 1B illustrates a ceramic package 100B housing therein an IC die 108, where the ceramic package 100B includes a plurality of levels of metallization structures formed by a selective deposition process, according to some other embodiments. The ceramic package 100B is similar to the ceramic package 100A (Figure 1A), except that the ceramic package 100B has two or more layers of ceramic layers (two layers shown in Figure 1B for clarity) interposed between the IC die 108 and the outside world, e.g., a PCB (not shown). In the ceramic package 100B, thermally conducting components include, in addition to the inner thermal pad 112 and the outer thermal pad 116, one or more intermediate thermal pads 126 formed at one or more vertical levels and one or more vias 120, e.g., thermal vias, formed at different vertical levels that thermally connect the inner thermal pad 112, the one or more intermediate thermal pads 126 and the outer thermal pad 116. In addition, electrically conducting components include, in addition to the inner electrical pad 124 and the outer electrical pad 128, one or more intermediate electrical pads 134 formed at one or more vertical levels, and one or more vias 134 formed at different vertical levels, that electrically connect the inner electrical pad 124, the one or more intermediate electrical pads 134 and the outer electrical pad 128.

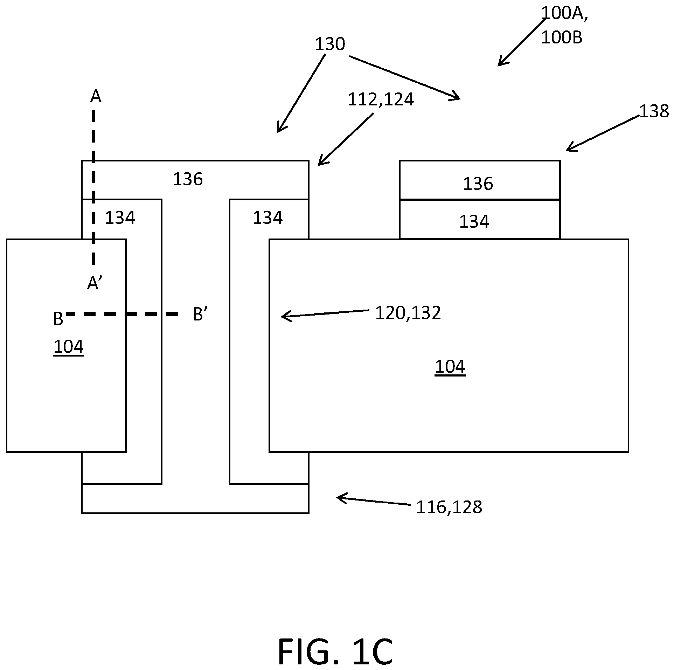

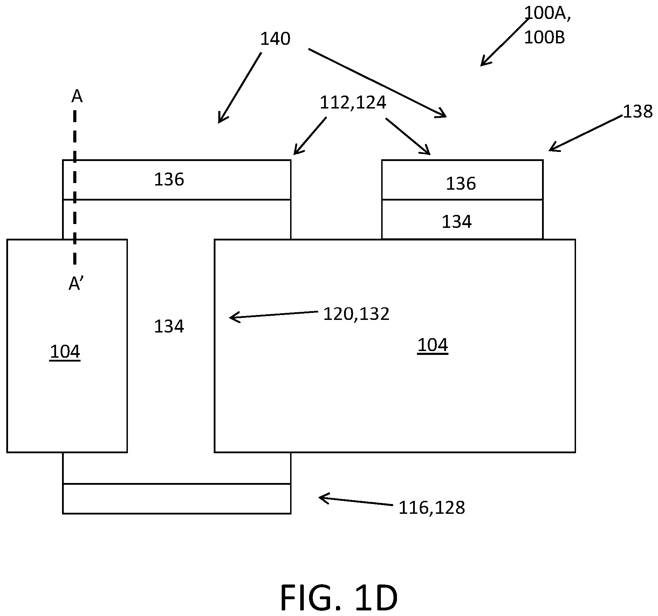

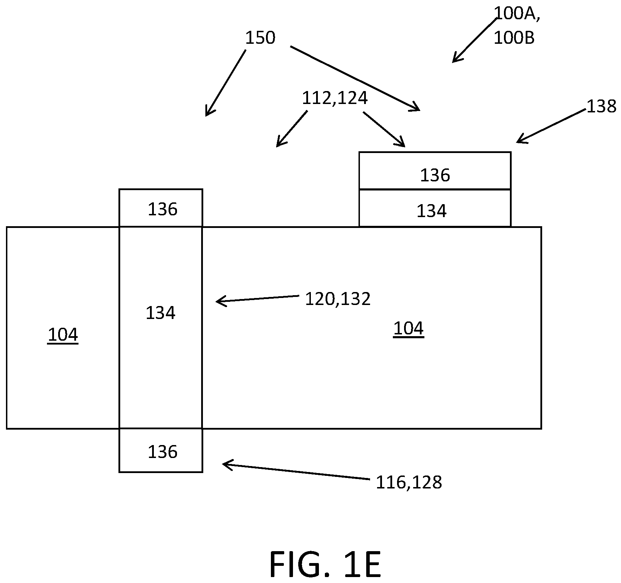

Figures 1C, 1D, and 1E illustrate portions of the ceramic packages 100A (Figure 1A) and/or 100B (Figure 1B) having metallization structures 130, 140, 150 that provide thermal/electrical communication between the IC die 108 (Figures 1A and 1B) and an interface to the outside world, e.g., a PCB, according to embodiments. In particular, the portion of the ceramic package illustrates a detailed view of the metallization structures 130 that includes the inner thermal/electrical pad 112/124, the outer thermal/electrical pad 116/128 and the via 120/132. The metallization structures 130 may additionally include one or more circuit elements 138, e.g., a passive circuit element such as a conductor (e.g., a wire), an electrode or a resistor, among other circuit elements. According to embodiments, the metallization structures 130 includes a base metal layer 134 formed on or in the ceramic substrate 104 and one or more layers of a stack 136 of metallization layers. In some embodiments, the base metal layer 134 can include a refractory metal. In some embodiments, the base metal layer 134 can be formed from a biocompatible metal. As described herein, a refractory metal can be one of Mo, W, Re, Nb, Ta, or an alloy (or mixture or composite) of Mo and Mn. In some embodiments, the refractory metal is deposited using a suitable technique, e.g., by screen printing, stencil printing, spin coating, applied by inks by various means including rollers, vacuum coating, dipping in a dispersion or by means of thin film processing such as sputtering or evaporation and can be, e.g., tungsten (W), molybdenum (Mo), an alloy (or mixture or composite or blend) of molybdenum (Mo) and manganese (Mn), an alloy (or mixture or composite or blend) of W and Mo, or an alloy (or mixture or composite or blend) of two or more of W, Mo, and Mn. In some embodiments, the refractory metal can consist essentially of one or more of W, Mo, and Mn and can also include incidental impurities that are each present at concentration of 5 wt. % or less, 2 wt. % or less, or 1 wt. % or less. In other embodiments, however, the base metal layer 134 can include a non-refractory metal, such as copper (Cu) or platinum (Pt). In representative embodiments, the base metal layer 134 does not include a magnetic metal (e.g., the base metal layer 134 does not include nickel).

The stack 136 of metallization layers includes an intermediate layer formed over the base metal layer 134 and a gold (Au) layer formed on the intermediate layer. In some embodiments, the Au layer, which can also be referred to as an Au-based layer, serves as a bonding pad for wires or solder to bond to and the intermediate layer can serve as a diffusion barrier that prevents or inhibits the Au and the metal that forms the base metal layer 134 from mixing together. As discussed in greater detail elsewhere in the application, in some embodiments, the metal that forms the intermediate layer and gold from the Au layer can at least partially blend together such that that the stack 136 includes a region between the Au layer and the intermediate layer that includes a mixture of Au and the metal that forms the intermediate layer.

In some embodiments, the intermediate layer comprises a noble metal-containing layer. As disclosed herein, the term "noble metal" refers to corrosion resistant metal elements and includes elements such as ruthenium, rhodium, palladium, osmium, iridium, and platinum. Additionally, although gold is often considered to be a noble metal, the noble metal-containing layer of stack 136 is typically formed from a noble metal other than gold at least because, as described below in greater detail, it is undesirable to form a layer of gold directly on a refractory metal layer because the refractory metal can undesirably diffuse into the gold, which can lead to embrittlement of the gold layer. In some embodiments, the intermediate layer comprises a non-magnetic metallic layer. In some embodiments, the intermediate layer comprises a palladium (Pd)-based layer. In embodiments where the intermediate layer comprises a Pd-based layer, the stack 136 can include a region between the Au-based layer and the Pd-based layer that includes a mixture of Pd and and Au. In some embodiments, the intermediate layer is deposited by electrolytic deposition. According to various embodiments, the intermediate layer is deposited by electroless-deposition and the Au-based layer is formed by an immersion process. In various embodiments, the intermediate layer is substantially free of phosphorous (P) and boron (B). For example, in some embodiments, the intermediate layer comprises 4 wt. % or less of P and/or 4 wt. % or less of B. Without limitation, the presence of P and/or B may be characteristic of electroless plating. In other embodiments, the intermediate layer is free of P and B.

In some embodiments, the stack 136 of metallization layers does not include a magnetic metal layer. More specifically, in some embodiments, the stack 136 of metallization layers does not include a nickel layer. In some embodiments, the stack 136 of metallization layers comprises biocompatible metals and does not include non-biocompatible metals. In the embodiment illustrated with respect to Figure 1C, the via 120/132 has a width that is substantially wider than twice the thickness of the base metal layer 134 formed therein. Accordingly, both the base metal layer 134 and one or more layers of the stack 136 fill the via 120/132 and vertically extend through the entire thickness of the ceramic substrate 104. In contrast, in the embodiment illustrated with respect to Figure 1D, the via 120/132 has a width that is substantially the same or narrower than twice the thickness of the base metal layer 134 formed therein. Accordingly, the base metal layer 134 substantially fills the via 120/132, which may be substantially free of the one or more layers of the stack 136, and extends through the ceramic substrate 104, while the stack 136 is formed on the surface of the base metal layer 134 outside of the via 120/132.

Still referring to Figures 1C, 1D, and 1E, in the illustrated embodiments, all layers of different ones (e.g., the circuit elements 138, vias 112/124) of the metallization structures 130, 140, 150 are physically separated. However, embodiments are not so limited and in other embodiments, one or more layers of the different ones of the metallization structures 130, 140, 150 are continuous. For example, the base metal layer 134 may form a continuous layer between different ones of the metallization structures 130, 140, 150.

Still referring to Figures 1C, 1D, and 1E, in the illustrated embodiments, the via structures 120, 132 may be used to form a hermetic seal to protect the IC enclosed by the ceramic substrate. However, when the via structures are not used to form a hermetic seal, the vias 120, 132 may not be filled to close off the opening. For example, in the embodiment illustrated with respect to Figure 1C, the stack 136 may not completely fill the vias 120, 132.

Still referring to Figures 1C, 1D, and 1E, in the illustrated embodiments, the stack 136 is illustrated as being formed on the upper (or lower) surface of the base metal layer 134 at least a portion of the stack 136 is be formed on one or more side surfaces of the base metal layer 134. Such may be the case, e.g., no sacrificial material is used to mask the area outside of he base metal layer 134, or when a step height exists between a sacrificial layer formed outside of the metal layer 134 and the metal layer 134 such that a small portion of the sidewall of the base metal layer 134 is exposed when the stack 136 is formed by plating.

In the embodiments shown in Figures 1C and 1D, the base metal layer 134 in the vias 120/132 extend outside of the vias 120/132 such that a portion of the base metal layer 134 is formed on the upper and lower surfaces of the ceramic substrate 104.

In some embodiments, the illustrated ceramic packages 100A/100B are flat no-leads (FN) packages, which can be, e.g., quad-flat no-leads (QFN) package or a dual-flat no-leads (DFN) package. Like other semiconductor package technologies, flat no-leads packages are configured to connect (both physically and electrically) ICs to a PCB using a surface-mount technology. FN packages can have a single or a multiple rows of pins. FN packages have an exposed thermal pad on the bottom of the package that can be soldered directly to a system PCB for optimal thermal transfer of heat from the die.

Some FN packages can be air-cavity flat no-leads packages having an air cavity designed into the package. Some FN packages can be plastic-molded flat no-leads packages having reduced air in the package compared to air-cavity flat no-leads packages. Some plastic-molded FN packages are used in relatively low frequency applications, e.g., less than about ~2-3 GHz. Plastic molded FN packages include a plastic compound filling a cavity in the packages without having a lid. In contrast, air-cavity FN packages are used in relatively high frequency applications, e.g., 20-25 GHz. Air-cavity FN packages include a plastic-molded body (open, and not sealed) and a lid, which can be formed of ceramic or plastic.

Compared to other types of packages, FN packages can advantageously reduce lead inductance, a small sized "near chip scale" footprint, thin profile and low weight. In addition, flat no-leads packages can have perimeter I/O pads to facilitate PCB trace routing, and can have exposed metal die-pad technology to enhance thermal and electrical performance. These and other features of flat no-leads packages enable their applications in many technologies where small size and weight are desired, as well as high thermal and electrical performance.

### Packages Formed by Co-firing a Ceramic Substrate and a Refractory Base Metal Layer, Followed by Selectively Forming Metallization Structures on the Refractory Metal Layer

In some applications, it may be desirable to protect the ICs from the ambience, e.g., by forming a hermetic enclosure for the ICs in addition to providing desirable electrical, mechanical and thermal properties. To address these and other needs, in some embodiments, the ceramic packages 100A, 100B (Figures 1A-1E) are formed using a high temperature co-firing process. As described herein, a high temperature co-firing process refers to a process of fabricating a ceramic package in which a "green" structure including a ceramic support structure, e.g., the ceramic substrate 104 (Figures 1A-1E), and other conductive, resistive and/or dielectric components formed of, e.g., the base metal layer 134 (Figures 1C, 1D, 1E), are cofired or sintered in a kiln at the same time. That is, instead of first forming a sintered ceramic support structure and subsequently forming other conductive, resistive and/or dielectric components, in these embodiments, a "green" structure formed of a mixture of organic compounds and unsintered ceramic compounds, as well as unsintered base metal structures, is cofired into their final form at the same time. The resulting high temperature co-fired ceramic (HTCC) package, according to embodiments, can provide protection of ICs from various undesirable environmental effects such as moisture, heat, thermal shock, thermal expansion, and corrosion, to name a few.

The ceramic package 100A/100B that includes the stack 136 of metallization layers formed on the base metal layer 134 (Figures 1C, 1D, and 1E) as part of the metallization structures 130, 140, 150 (Figures 1C, 1D, and 1E) mitigate various problems recognized in the relevant industry, including degradation associated with diffusion or cross-diffusion of elements between different regions or layers of the metallization structures 130, 140, 150. In the following, a detailed description of forming the ceramic substrate, the base metal layer, and selectively forming the stack of metallization layers on the base metal layer is provided, whose benefits include, e.g., improved adhesion of the stack of metallization layers to the base metal layer, improved planarity of the stack of metallization layers, reduced corrosion of the layers of the stack of metallization layer, reduced electrical shorts from the selective formation of the stack of metallization layers on the base metal layer against adjacent ceramic surfaces, biocompatibility of the resulting metallization structures, and various manufacturing advantages, to name a few.

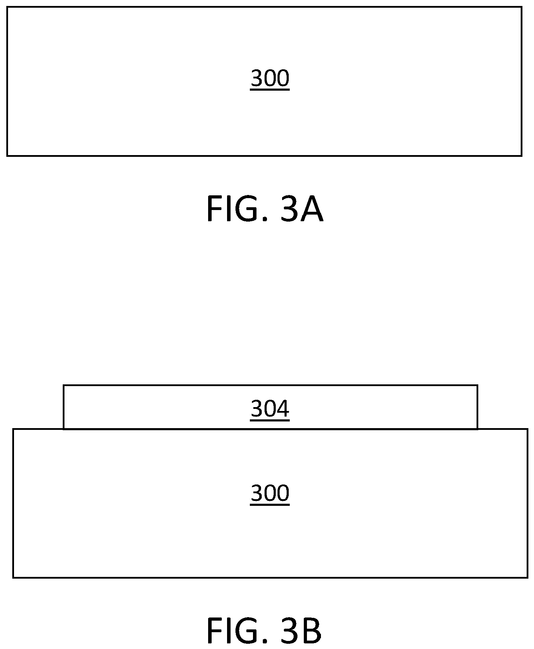

FIGS. 3A-3D illustrate intermediate structures at various stages of fabricating the ceramic package 100A/100B illustrated with respect to Figures 1A-1E, e.g., based on the processes illustrated in Figure 2, according to embodiments.

As shown in Figure 3A, at step 204, an unfired ceramic substrate 300 is provided. In some embodiments, the unfired ceramic substrate is a "green" structure that is formed from a slurry or a paste formed of unfired ceramic powder, organic solvents, and a binder. The unfired substrate 300 is formed by casting the slurry or paste into a sheet and then cutting the sheet into a ceramic "green" tape. According to various embodiments, the ceramic powder includes a suitable material for forming a ceramic substrate (e.g., substrate 104 shown in Figures 1A-1E). For example, in some embodiments, the ceramic powder comprises an aluminum-based material, such as aluminum oxide (e.g., Al₂O₃) and/or aluminum nitride (AlN). However, embodiments are not so limited, and the ceramic powder can be formed of other materials, e.g., BeO, silicon carbide (SiC), silicon nitride (Si₃N₄), low temperature co-fired ceramic (LTCC) substrates, silicon dioxide (SiO₂), and zirconia (ZrO₂), to name a few. In some embodiments, the ceramic "green" tape may further comprise silica-based glass powder, e.g., about 4%-10% on the basis of a combined weight of aluminum oxide and/or aluminum nitride powder and the glass powder. However, embodiments are not so limited and in other embodiments, the substrate 300 may represent a pre-sintered ceramic substrate, e.g., a sintered aluminum oxide (e.g., Al₂O₃) substrate and/or a sintered aluminum nitride (AlN) substrate. Still in other embodiments, the substrate 300 may represent other inorganic substrates, e.g., a glass or a glass ceramic substrate, an organic substrate, e.g., the plastic substrate of a PCB or a semiconductor substrate, to name a few, where selective formation of metallization structures may be desired.

At step 208, the "green" tape is punched to form cavities or hollow vias through the ceramic "green" tape.

As shown in Figure 3B, at step 212, a layer 304 of conductive metal is deposited onto the substrate 300 to form metallization structures. According to some embodiments, the layer 304 of conductive metal can be formed using a metal ink/paste, which can include a refractory metal powder (e.g., a powder comprising tungsten (W), molybdenum (Mo) powder, a Mo-Magnesium (Mg) alloy/mixture/composite/blend, a W-Mo alloy/mixture/composite/blend, and/or a W-Mo-Mg alloy/mixture/composite/blend), organic solvents, and a binder. In some other embodiments, the layer 304 of conductive metal can be formed using a direct deposition process such as physical vapor deposition process or chemical vapor deposition process. In addition, the layer 304 can be formed of a non-refractory metal that is suitable for the co-firing process, such as Pt, Pd, Cu, or Ag. According to embodiments, the base metal layer 134 may have a thickness in a range of 0.1 µm to 100 µm or greater, 1 µm to 100 µm, 1 µm to 25 µm, 25 µm to 50 µm, 50 µm to 75 µm, 75 µm to 100 µm or any range defined by these values.

In some embodiments, the metallization structures formed by the layer 304 include circuit patterns on a surface of the "green" substrate 300. Accordingly, in these embodiments, depositing the conductive metal ink/paste to form metallization structures includes forming the circuit patterns on the substrate 300 using the conductive metal ink/ paste. In some embodiments, the metallization structures formed by the layer 304 include vias, castellations, cavities, and/or pedestals formed in and/or through the substrate 300. In these embodiments selectively depositing the conductive metal ink/paste onto the "green" substrate to form metallization structures includes at least partially filling or lining the cavities or hollow vias in the "green" tape (e.g., the cavities or hollow vias formed at step 208) with the conductive metal ink/paste.

The metal ink/paste is deposited onto the substrate 300 to form the metallization structures using any suitable technique. For example, in some embodiments, the metal ink/paste is selectively deposited onto the substrate 300 using a screen printing process. In other embodiments, however, other deposition techniques and processes such as a direct deposition process, e.g., physical vapor deposition process, can be used. For example, in some embodiments, a blanket layer of the metal ink/paste is first deposited on the substrate 300 and then the blanket layer is patterned and etched (e.g., using a photomask) to selectively remove excess metal ink/paste and expose the ceramic substrate 300 and form the base metal layer 304. Other suitable processes can also be used, such as lift-off process that does not involve etching the metal.

In some embodiments, the ceramic package includes multiple ceramic layers stacked together, as illustrated in Figure 1B. In these embodiments, after step 212, a laminated stack of "green" tapes can be formed by stacking and compacting multiple of the "green" substrates 300 having metallization structures formed thereon into a monolithic structure in which metallization structures at different vertical levels are monolithically interconnected. For example, metallization structures on one of the "green" tapes can be electrically connected to metallization structures on another "green" tape via the partially-filled cavities or hollow vias formed in the "green" tapes.

At step 216, subsequent to the conductive metal ink/paste being selectively deposited onto the "green" substrate 300, the ceramic/refractory metal composite is sintered or "co-fired" in a controlled atmosphere and temperature. During sintering, solvents and other organics in in the conductive metal ink or paste evaporate, thereby forming the base metal layer 304. In addition, during sintering, the ceramic powder coalesces to form grains of the ceramic substrate 300. The controlled atmosphere can include, e.g., hydrogen or a hydrogen-nitrogen mixture, e.g., forming gas. In embodiments where the base metal layer comprises a refractory metal, the controlled temperature can be in a range of, e.g., 1200°C-1900°C, 1400°C-1700°C, 1500°C-1650°C or any range defined by these values that is sufficient to sinter ceramic and metal powders of the "green tape" having formed thereon printed conductive ink/paste structures. In some embodiments, the controlled temperature can depend on the ceramic material. For example, for some AlN-based materials, the controlled temperature may be in a range of, e.g., 1650°C-1900°C, and for some Al₂O₃-based materials, the controlled temperature may be in a range of, e.g., 1300°C-1650°C.

It will be appreciated that the co-firing process as described herein can be advantageous for forming metallization stacks having relatively complex shapes. Because the ink/paste can fill relatively complex cavities, e.g., trenches or vias, the resulting base metal layer 304 integrated with the ceramic substrate can have shapes and aspect ratios that are difficult or impossible to achieve by other means such as evaporation or vapor deposition of the metal into a patterned substrate. Advantageously, at least a portion of the metallization stack can be embedded in the ceramic substrate, as described above with respect to Figures 1C, 1D, and 1E.

As described elsewhere in the application, the layer of conductive metal 304 can be formed of a refractory metal. Such layer can be formed using a conductive metal ink/paste, which includes refractory metal powders, such as tungsten (W), molybdenum (Mo), silicon carbide (SiC), and/or an alloy (or mixture or composite) of Mo and manganese (Mn), such that, after co-firing, the base metal layer 304 comprises a layer of refractory metal. The layer of conductive metal 304 can be formed using other processes, such as direct deposition techniques including physical or chemical vapor deposition. In other embodiments, however, other metals can be used instead of refractory metal. Specifically, in some embodiments, the layer of conductive metal 304 can be formed of a non-refractory metal that is suitable for the co-firing process, such as Pt, Pd, Cu, or Ag. Yet in other embodiments, the layer of conductive metal 304 can include both refractory metal and non-refractory metal. The layer of conductive metal 304 can be formed using an ink/paste or a direct deposition process such as physical vapor deposition. During co-firing, the non-refractory metal can melt, such that the resulting base metal layer 304 can include refractory metal particles, e.g., W or Mo particles, which can be sintered, and inter-particle spaces that are filled or infiltrated by the non-refractory metal, e.g., Cu.

Advantageously, because the co-firing process is performed at a relatively high temperature, the surface of the substrate 300 may be rendered substantially free of undesirable organic or inorganic residues or contaminants that may be present when an ink/paste is used. As a result, under some circumstances, a cleaning process that is used in other technologies for removing such residues or contaminants prior to forming additional layers as described below may be omitted.

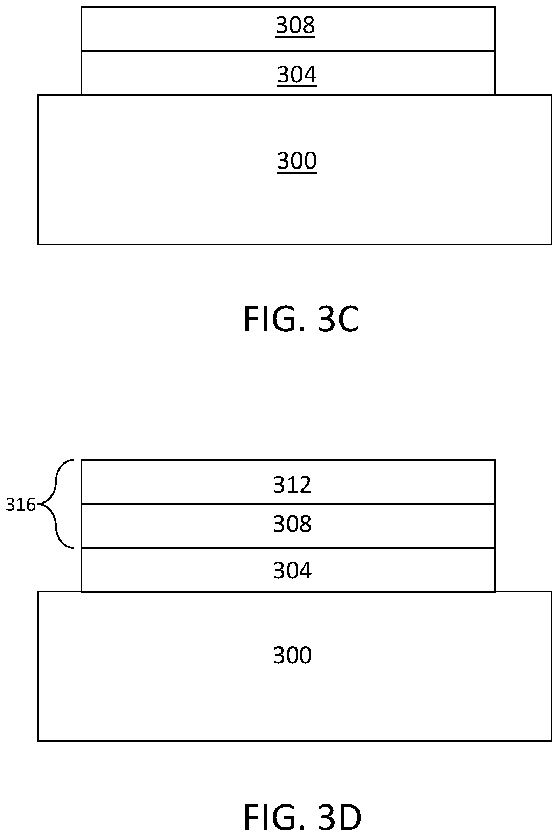

After co-firing the substrate 300 and the base metal layer 304, the ceramic/metal composite undergoes post-fire processing. In some embodiments, the post-fire processing includes additional metallization, sawing, machining, and brazing of the ceramic metal composite. In some embodiments, post-fire processing includes depositing a stack (e.g., stack 136 shown in Figures 1C, 1D, and 1E) of metallization layers on the base metal layer 304. Accordingly, as shown in Figure 3C, at step 220, an intermediate layer 308 is formed on the base metal layer 304. In some embodiments, the intermediate layer 308 comprises a noble metal-containing layer. In some embodiments, intermediate layer 308 comprises a non-magnetic metallic layer. In some embodiments, the intermediate layer 308 comprises a palladium (Pd)-based layer. As will be described in greater detail elsewhere in the application, the intermediate layer 308 is configured to reduce corrosion of the base metal layer 304. Additionally, the intermediate layer 308 may serve as an anti-oxidation layer and/or an anticorrosion layer which improves solderability.

In some embodiments, the intermediate layer 308 is formed using an electroless deposition process. Specifically, the intermediate layer 308 can be formed on the base metal layer 304 by electroless plating a non-magnetic metal such as Pd or another noble metal onto a surface of the base metal layer 304 using a plating bath. In other embodiments, however, the intermediate layer 308 is formed on the base metal layer 304 by electrolytic plating. In still other embodiments, the intermediate layer 308 is formed on the base metal layer 304 using a non-plating process. For example, in some embodiments, the intermediate layer 308 is formed using a physical vapor deposition (PVD) process whereby a metal vapor (e.g., a Pd vapor) condenses on the surface of the base metal layer 304, thereby forming the intermediate layer 308. In these embodiments, a mask layer can be selectively formed over ceramic substrate 300 and/or side surfaces of the base metal layer 304 to prevent the metal atoms from condensing directly on the ceramic substrate 300 and/or the side surfaces of the base metal layer 304. According to embodiments, the thickness of the intermediate layer 308 is about 0.05 µm, 0.1 µm, 0.2 µm, 0.5 µm, 1 µm, 5 µm, 10 µm, 20 µm, more than 20 µm, or a value in a range defined by any of these values.

As shown in Figure 3D, at step 224, after forming the intermediate layer 308, a gold (Au)-based layer 312 is deposited on the intermediate layer 308 to form at least part of the stack 316 of metallization layers. The Au-based layer 312 provides various advantages, including oxidation resistance, low resistivity and protection of the underlying intermediate layer 308 from reacting with the ambient environment, among other advantages.

In some embodiments, the Au-based layer is formed using an immersion process. As described herein, an immersion process refers to a solution-based chemical process in which a chemical displacement reaction occurs to deposit a layer of metal, e.g., Au, onto a base metal, e.g., Pd. In an immersion reaction, the base metal dissolves, releasing the electrons that reduce the positively charged ions of the metal present in a solution. Driven by an electrochemical potential difference, the metal ions in solution (e.g., Au ions) are deposited onto the surface of the base metal, while displacing ions of the base metal into the solution. The reaction can continue as long as the base metal is available to supply electrons for the displacement reaction, which can occur according to one or more of the following reactions:

Pd⁰ → Pd⁺⁺ + 2e⁻ [1]

2Au⁺ + 2e⁻ + → 2Aᵤ⁰ [2]

2Au⁺ + Pd⁰→ 2Au⁰↓ + Pd⁺⁺ [3]

In the illustrated embodiments, the Au-based layer 312 is formed directly on the underlying intermediate layer 308. In such embodiments, the Au-based layer 312 may be in direct contact with the intermediate layer 308, e.g., without an intervening layer such as a seed layer formed of, e.g., copper. It will be appreciated that, while an immersion process has been described for forming the Au-based layer 312, embodiments are not so limited, and in other embodiments, the Au-based layer 312 can be formed using other processes such as electro- and electroless plating processes and deposition processes.

In some embodiments, the noble metal elements may diffuse to and from one or both of, or interdiffuse between, the intermediate layer 308 and the Au-based layer 312. Such diffusion or interdiffusion can occur, for example, as a result of a thermal anneal performed after forming the stack 316. In these embodiments, a noble metal element may diffuse from one to the other of the intermediate layer 308 and the Au-based layer 312. For example, Pd from the intermediate layer 308 may diffuse into the Au-based layer, and/or Au from the Au-based layer 312 may diffuse into the intermediate layer 308. Under these circumstances, one or both of the intermediate layer 308 and the Au-based layer 312 may be a solid solution formed by Au and Pd. Further, when the diffusion or interdiffusion occurs after the layers are formed, the concentration profile of Pd in the Au-based layer 312 may generally decrease towards an upper surface thereof (away from the ceramic substrate 300), where the concentration profile Pd is characteristic of a thermally diffused profile. Similarly, the concentration profile of Au in the intermediate layer 308 may generally decreases towards a lower surface thereof (towards the ceramic substrate 300), where the concentration profile of Au is characteristic of a thermally diffused profile.

While noble metals may diffuse to and/or from the intermediate layer 308 and/or the Au-based layer 312, it will be appreciated that, as to other elements, the intermediate layer 308 may serve as a diffusion barrier. For example, in some other embodiments, the intermediate layer 308 can serve as a diffusion barrier layer that substantially suppresses and/or restricts diffusion of some compounds and elements, e.g., elements other than Pd or Au, from diffusing through the intermediate layer 308. For example, in embodiments where the Au-based layer 312 is formed using an immersion process, the intermediate layer 308 protects the underlying base metal layer 304 from corrosion caused by the immersion process by preventing elements in the solution used in the immersion process from diffusing through the intermediate layer 308 and into the base metal layer 304. The chemicals and compounds in the immersion solution can be corrosive to the base metals that form the base metal layer 304. Accordingly, the intermediate layer 308 can reduce or essentially eliminate corrosion of the base metal layer 304 caused by the deposition of Au-based layer 312. Similarly, under some circumstances, the intermediate layer 308 can also prevent (or at least drastically reduce) the diffusion of the base metal from the base metal layer 304 into the Au-based layer 312. It has been found that, under some circumstances, over time, refractory metals can diffuse into and through the Au-based layer 312, e.g., through the crystal boundaries, which can result in embrittlement of the Au-based layer 312 and cause a wire bond wire attached to the Au-based layer 312 to fail to adequately stick to the Au-based layer 312. Accordingly, the presence of the intermediate layer 308 improves bondability of the surface of the Au-based layer 312 (Figure 3C). Additionally, in embodiments where the top-most layer of the stack 316 comprises a solid solution of Au and Pd, the Au-Pd solid solution can still serve as a suitable bonding pad for a wire bond wire to attach to.

An additional benefit of the intermediate layer 308 is that it allows the Au-based layer 312 to have a relatively low thickness, thereby lowering cost. In some embodiments, the thickness of the Au-based layer 312 is about 0.05 µm - 10 µm, 0.05 µm - 1 µm, 0.05 µm - 0.5 µm, 0.05 µm - 0.2 µm, 0.05 µm - 0.15 µm, or is in a range defined by any of these values. In embodiments where the Au-based layer 312 is formed as part of industry standard packages, the thicknesses can have certain minimum values. For example, according to ASTM B-488 and MIL-DTL-45204 standards, the Au-based layer 312 can have minimum thicknesses according to TABLES 1 and 2, respectively, or minimum thicknesses in a range defined by any of the minimum thicknesses in the respective tables.

**TABLE 1 MINIMUM AU THICKNESSES (ASTM B-488)**

| Class | Minimum Thickness, µm |
|---|---|
| 0.25 | 0.25 |
| 0.50 | 0.50 |
| 0.75 | 0.75 |
| 1.0 | 1.0 |
| 1.25 | 1.25 |
| 2.5 | 2.5 |
| 5.0 | 5.0 |

**TABLE 2 MINIMUM AU THICKNESSES (MIL-DTL-45204)**

| Class | Minimum Thickness (Inches) | Minimum Thickness (µm) |
|---|---|---|
| Class 00 | 0.00002 | 0.508 |
| Class 0 | 0.00003 | 0.762 |
| Class 1 | 0.00005 | 1.27 |
| Class 2 | 0.00010 | 2.54 |
| Class 3 | 0.00020 | 5.08 |
| Class 4 | 0.00030 | 7.62 |
| Class 5 | 0.00050 | 12.7 |
| Class 6 | 0.00150 | 38.1 |

The intermediate layer 308 and the Au-based layer 312 is be conformally plated such that they extend over the sides of the layer on which they are formed. The intermediate layer 308 is be conformally plated on the base metal layer 304 such that the intermediate layer 308 at least partially covers one or more side surfaces of the base metal layer 304. In some embodiments, the Au-based player 312 can be conformally plated on the intermediate layer 308 such that the Au-based layer 312 at least partially covers one or more side surfaces of the intermediate layer 308.

In the embodiments shown and described above, the stack 316 of metallization layers includes only the intermediate layer 308 and the Au-based layer 312. In other embodiments, however, the stack can include additional metal layers. For example, in some embodiments, the stack 316 can include a layer of gold-tin (AuSn) solder formed on the Au-based layer 312. In representative embodiments, however, the stack 316 does not include a magnetic metal. For example, in embodiments of the present technology, the stack 316 does not include a layer of nickel. Furthermore, in addition to the stack 316 not including a magnetic metal such as nickel, in some embodiments, the entire ceramic package does not include a layer of a magnetic material formed on the ceramic substrate 300.

In the embodiments shown and described above, the stack 316 includes both the intermediate metal layer and the Au-based layer.

### IC Packages Having One or More Metallization Structures

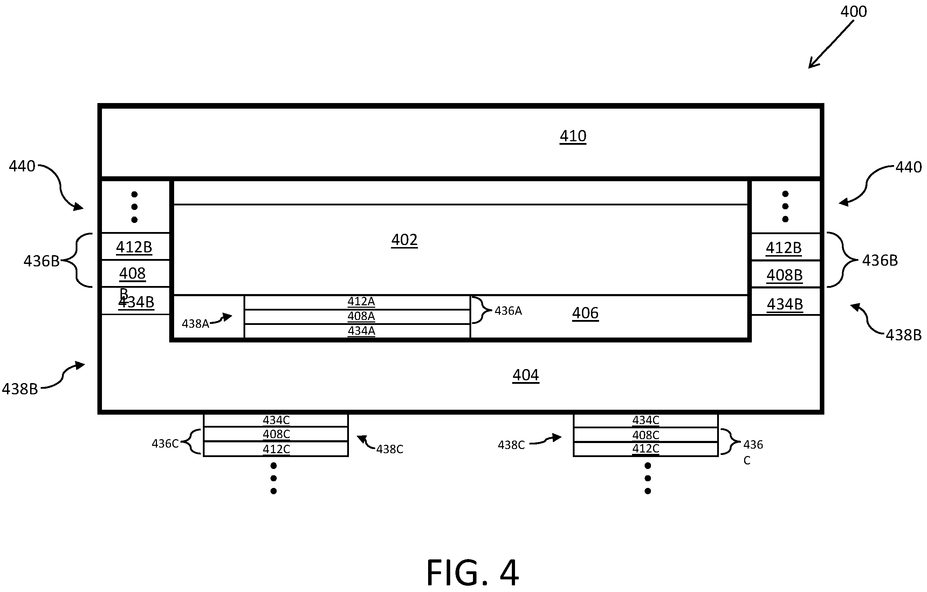

Figure 4 illustrates a ceramic package 400 housing therein an IC die 402. The ceramic package 400 includes a ceramic substrate 404 that defines a cavity 406 and also includes a lid 410 disposed over the cavity 406 and IC die 402. The ceramic substrate 404 may be generally similar to the ceramic substrate 104 described above in connection with Figures 1A and 1B. The ceramic package 400 includes one or more metallization structures 438 that provide thermal/electrical communication between the IC die 402 and an interface to the outside world. In some embodiments, the lid 410 comprises a ceramic material.

Each of the metallization structures 438 include a base metal layer 434 formed on the ceramic substrate 404 and a stack 436 of metallization layers formed on the base metal layer 434. The base metal layer 434 may be generally similar to the base metal layer 134 described above in connection with Figures 1C, 1D, 1E and 3A-3C. Specifically, the base metal layers 434 may comprise a non-magnetic metal (e.g., a refractory metal such as W, Mo, or an alloy of Mo and Mn, or a noble metal such as Pt) that has been co-fired with the ceramic substrate 404 such that the base metal layers 434 and the ceramic substrate 404 form a co-fired substrate. Similarly, the stack 436 of metallization layers may be generally similar to the stack 136 described above in connection with Figures 1C, 1D, 1E, and 3A-3C. Specifically, the stack 436 of metallization layers includes intermediate layer 408 formed from a non-magnetic metal (e.g., Pd) and a layer 412 of Au formed directly on the intermediate layer 408. In some embodiments, the intermediate layer 408 comprises a non-magnetic metallic layer. In some embodiments, the intermediate layer 408 comprises a noble metal-containing layer. In some embodiments, the intermediate layer comprises a non-magnetic metallic layer. In some embodiments, the stack 436 does not include a magnetic metal.

In the illustrated embodiment, the ceramic package 400 includes several different metallization structures 438A-438C. While the different metallization structures 438A-438C are shown as being integrated in the same ceramic package 400 for illustrative purposes, it will be appreciated that various implementations of the ceramic package 400 can include a subset thereof including some but not others of the metallization structures 438A-438C.

The illustrated ceramic package 400 includes the metallization structure 438A formed within the cavity 406 on a bottom portion of the ceramic substrate 404 and directly coupled to the IC die 402. The metallization structure 438A comprises a base metal layer 434A and a stack 436A of metallization layers. The stack 436A in turn includes an intermediate layer 408A and an Au-based layer 412A in a similar manner as described above. The Au-based layer 412A may be in direct electrical contact with electrical contacts on the IC die 402 and can be configured to efficiently transfer electrical signals to and from the IC die 402.

The ceramic package 400 also includes metallization structures 438B, which form at least a portion of the sidewalls that define the cavity 406. The metallization structures 438B comprise a base metal layer 434B and a stack 436B of metallization layers. The stack 436B in turn includes an intermediate layer 408B and an Au-based layer 412B. The Au-based layers 412B can be electrically connected to external circuitry (e.g., via wire bonds or solder connections) and can be configured to facilitate the transfer of electrical signals between the ceramic package 400 and the external circuitry. In some embodiments, the Au-based layers 412B can be in direct electrical contact with circuitry on the IC die 402 (e.g., via wire bonds) such that the Au-based layers 412B are configured to transmit and receive electrical signals directly to the IC die 402. In other embodiments, however, the Au-based layers 412B receive and transmit the electrical signals via the metallization structure 438A or some other metallization structure 438. Advantageously, the metallization structure 438B can also be configured to form part of the hermetic seal that isolates the cavity 406 from the external environment.

The ceramic package 400 also includes metallization structures 438C, which are formed on a bottom side of the ceramic substrate 404. The metallization structures 438C each comprise a base metal layer 434C and a stack 436C of metallization layers. The stack 436C in turn includes an intermediate layer 408C and an Au-based layer 412C. While metallization structures 438A and 438B are configured such that the stacks 436A, 436B are disposed over the base metal layers 434A, 434B and the ceramic substrate 404 and the Au-based layers 412A, 412B are disposed over the intermediate layers 408A, 408B, embodiments are not so limited, and the metallization structures 438C can have an inverse orientation such that the stacks 436C are disposed below the base metal layers 434C and the ceramic substrate 404 while the Au-based layers 412C are disposed below the intermediate layers 408C. In this way, the base metal layers 434C can be formed directly on the ceramic substrate 404 (e.g., via a co-firing process) and the stack 434C can be configured such that the intermediate layers 408C are positioned between the base metal 434C and Au-based layer 412C. Accordingly, while the metallization structures 438C have an inverse orientation compared to metallization structures 438A, 438B, the structure and order of the individual layers within the metallization structures 438C is the same as for the metallization structures 438A, 438B.

In some embodiments the metallization structures 438A, 438B, and 438C can be formed in separate processes. In other embodiments, however, the metallization structures 438A, 438B, and 438C can be co-plated such that one or more portions of each of the metallization structures 438A, 438B, and 438C are formed at the same time. For example, in some embodiments, the base metal portions 434A, 434B, and 434C are all formed during a single co-firing process. In these embodiments, a conductive metal, e.g., a conductive metal ink/paste, can be selectively deposited onto the green substrate, and the green substrate and conductive metal can be cofired to form the ceramic substrate 404 and base metal portions 434A, 434B, and 434C. Similarly, in some embodiments, each of the intermediate layers 408A, 408B, 408C can be formed in a single plating or deposition process and each of the Au-based layers 412A, 412B, and 412C are formed in a single plating or deposition process.

While not shown for clarity, it will be appreciated that, as described above, the ceramic package 400 may be a co-fired package, which may advantageously include portions of the metallization structures 438A-438C that are embedded within the ceramic substrate 404. In these embodiments, at least a portion of the metallization structures, e.g., at least the base metal layers 434A-434C may be embedded in the ceramic substrate 404, in a manner similar to the arrangements described above with respect to Figures 1C, 1D, and 1E. The embedded portions of the metallization may be such that different ones of the metallization structures 438A-438C may be physically and electrically connected to each other through the ceramic substrate 404, e.g., through embedded portions thereof, as illustrated in Figures 1C, 1D and 1E.

In some embodiments, ceramic package 400 includes additional metallization layers than those shown in Figure 4. Nevertheless, while not shown for clarity, it will be appreciated that the additional metallization layers or connections, e.g. solder, wire bond or brazing formed on the top layer of the stack 436, can also free of any magnetic material. For example, in some embodiments, the sidewalls that form the cavity can include additional metallization layers 440 between the stack 436B and the lid 410. For example, in some embodiments, the sidewalls can include a layer of gold-tin (AuSn) solder. In other embodiments, the additional metallization layers 440 can include an additional metallization structure 438 between the metallization structure 436B and the lid 410. For example, in embodiments where the lid 410 comprises a ceramic material, the sidewalls can include an additional metallization structure 438 having an inverse orientation (e.g., the orientation shown and described in connection with metallization structure 438C). In these embodiments, a base metal layer 434 is formed on a surface of the ceramic lid 410 (e.g., via a co-firing process), an intermediate layer 408 is formed on the base metal layer 434, and an Au-based layer 412 is formed on the intermediate layer 408. The lid 410 can then be inverted and positioned over the cavity 406 to close the cavity 406 and the additional metallization structure 438 can be attached to the metallization structure 436B (e.g., with a layer of gold-tin solder). In some embodiments, ceramic structure 440 can also include additional metallization layers below the metallization structures 438C.

### IC Packages Having a Base Metal Layer Formed from Non-Refractory Metals

In the previously described embodiments, the ceramic packages include a base metal layer formed from a refractory metal such as tungsten or molybdenum. In other embodiments, however, the base metal layer can be formed from a non-magnetic, non-refractory metal. For example, in some embodiments, the base metal layer can comprise copper (Cu) or can comprise platinum (Pt). In embodiments where the base metal layer comprises a non-refractory metal, however, the base metal layer and ceramic can generally not be co-fired or must be co-fired at a lower temperature (than embodiments where the base metal layer is formed from a refractory metal). This is because the temperature required for the ceramic powder to sinter and form a substrate can be higher than the sintering temperature for powders of most non-refractory metals, which means that co-firing the non-refractory base metal layer and the ceramic substrate would result in the non-refractory metal melting before the ceramic powder sinters. The premature melting of the non-refractory metal could result in the non-refractory metal undesirably flowing through and/or away from the ceramic substrate, which could prevent the base metal layer from functioning as a base metal layer for the stack of metallization layers and/or degrade the ceramic substrate. In embodiments where the base metal layer includes a non-refractory metal, the process of forming the ceramic substrate and the base metal layer will be different than embodiments where the base metal layer is a refractory metal.

The process of forming a non-refractory metal base metal layer can depend on the melting point of the specific non-refractory metal that the base metal layer is formed from. For example, in embodiments where the base metal layer includes copper, the "green" ceramic substrate is fired first and then the Cu base metal layer is formed on the fired ceramic substrate. Copper has a melting point of 1085°C, which is significantly lower than the sintering temperature of the ceramic material that forms the substrate, so the ceramic substrate must be fired before the Cu base metal layer is formed to prevent the Cu from prematurely melting. In some embodiments, the Cu base metal layer is formed by depositing the Cu-containing metal ink or paste onto the fired ceramic substrate and then firing the Cu/ceramic composite at a lower temperature (e.g., at a temperature lower than the melting temperature of Cu) to cause the Cu metal to sinter. However, some non-refractory metals can have a melting temperature that is much closer to that of the ceramic material. For example, platinum has a melting temperature of 1,768°C, which is higher than the sintering temperature for some ceramic materials that forms the substrate. Accordingly, in embodiments where the base metal layer includes platinum, the ceramic substrate and base metal layer can be formed in a co-firing process that includes depositing Pt-containing metal ink or paste onto a green ceramic substrate and then co-firing metal ink/paste and green ceramic substrate at a temperature less than 1768°C.

After forming the non-refractory metal base metal layer, metallization layers can then be formed on the base metal layer. In some embodiments, the metallization layers can include an intermediate layer (e.g., intermediate layers 308, 408) and an Au-based layer (e.g., Au-based layers 312, 412).

Aspects of this disclosure can be implemented in various electronic devices. Examples of electronic devices can include, but are not limited to, consumer electronic products, parts of the consumer electronic products, electronic test equipment, cellular communications infrastructure such as a base station, etc. Examples of the electronic devices can include, but are not limited to, a mobile phone such as a smart phone, a wearable computing device such as a smart watch or an ear piece, a telephone, a television, a computer monitor, a computer, a modem, a hand held computer, a laptop computer, a tablet computer, a personal digital assistant (PDA), a microwave, a refrigerator, a vehicular electronics system such as an automotive electronics system, a stereo system, a DVD player, a CD player, a digital music player such as an MP3 player, a radio, a camcorder, a camera such as a digital camera, a portable memory chip, a washer, a dryer, a washer/dryer, peripheral device, a clock, etc. Further, the electronic devices can include unfinished products.

Unless the context clearly requires otherwise, throughout the description and the claims, the words "comprise," "comprising," "include," "including" and the like are to be construed in an inclusive sense, as opposed to an exclusive or exhaustive sense; that is to say, in the sense of "including, but not limited to." The word "coupled", as generally used herein, refers to two or more elements that may be either directly connected, or connected by way of one or more intermediate elements. Likewise, the word "connected", as generally used herein, refers to two or more elements that may be either directly connected, or connected by way of one or more intermediate elements. Additionally, the words "herein," "above," "below," "infra," "supra," and words of similar import, when used in this application, shall refer to this application as a whole and not to any particular portions of this application. Where the context permits, words in the above Detailed Description using the singular or plural number may also include the plural or singular number, respectively. The word "or" in reference to a list of two or more items, that word covers all of the following interpretations of the word: any of the items in the list, all of the items in the list, and any combination of the items in the list.

Moreover, conditional language used herein, such as, among others, "can," "could," "might," "may," "e.g.," "for example," "such as" and the like, unless specifically stated otherwise, or otherwise understood within the context as used, is generally intended to convey that certain embodiments include, while other embodiments do not include, certain features, elements and/or states. Thus, such conditional language is not generally intended to imply that features, elements and/or states are in any way required for one or more embodiments or whether these features, elements and/or states are included or are to be performed in any particular embodiment.

## Claims

1. A ceramic package 100A, 100B configured to house an electronic device, 108 the ceramic package comprising:
a ceramic substrate 104 integrated with a non-magnetic metallization stack, 130 wherein
the ceramic substrate comprises a first upper surface, a lower surface, and at least one opening 120, 132 extending from the upper surface to the lower surface; and
the non-magnetic metallization stack comprising:
a base metal layer 134 formed on the ceramic substrate, wherein the base metal layer is formed by co-firing a refractory metal with the ceramic substrate, wherein the base metal layer extends through the opening and is formed on the first upper surface, wherein the base metal layer comprises a second upper surface and one or more side surfaces, and wherein the second upper surface at least partially extends over the first upper surface,
a noble metal-containing layer 308 conformally plated on the base metal layer such that the noble metal-containing layer covers the second upper surface of the base metal layer and at least partially covers the one or more side surfaces of the base metal layer, and
a gold (Au)-based layer 312 formed directly on the noble metal-containing layer.

2. The ceramic package of Claim 1 wherein the refractory metal comprises one or both of tungsten (W) and molybdenum (Mo).

3. The ceramic package of Claim 1 wherein the noble metal-containing layer comprises palladium (Pd).

4. The ceramic package of Claim 1 wherein the ceramic package does not include nickel (Ni) between the Au-based layer and the ceramic substrate.

5. The ceramic package of Claim 1 wherein the noble metal-containing layer at least partially fills the at least one opening.

6. The ceramic package of Claim 1 wherein at least a portion of the base metal layer is embedded in the ceramic substrate.

7. The ceramic package of Claim 6, wherein the noble metal-containing layer extends vertically through an entire thickness of the ceramic substrate.

8. The ceramic package of Claim 1 wherein at least a portion of the base metal layer and the ceramic substrate form a coplanar surface.

9. The ceramic package of Claim 1, wherein the noble metal-containing layer comprises 4 wt. % or less of phosphorus (P) or boron (B) or wherein the noble metal-containing layer is free of one or both of P and B.

10. The ceramic package of Claim 1 further comprising a lid, 410 wherein the ceramic substrate defines a cavity 406 configured to house the electronic device, wherein the lid is configured to hermetically seal the electronic device in the cavity, and wherein the non-magnetic metallization stack serves as a sealant disposed between a rim of the cavity and the lid.

11. The ceramic package of Claim 1 wherein each of opposing surfaces of the ceramic substrate has formed thereon the non-magnetic metallization stack, and wherein the non-magnetic metallization stacks on the opposing surfaces of the ceramic substate are optionally connected by a common base metal layer extending through an entire thickness of the ceramic substrate.

## Patentansprüche

1. Keramikgehäuse 100A, 100B, das dazu konfiguriert ist, eine elektronische Vorrichtung 108 aufzunehmen, wobei das Keramikgehäuse umfasst:
ein Keramiksubstrat 104, das mit einem nichtmagnetischen Metallisierungsstapel 130 integriert ist, wobei
das Keramiksubstrat eine erste Oberseite, eine Unterseite und mindestens eine Öffnung 120, 132, die sich von der Oberseite zu der Unterseite erstreckt, umfasst;
und
der nichtmagnetische Metallisierungsstapel umfasst:
eine auf dem Keramiksubstrat gebildete Basismetallschicht 134, wobei die Basismetallschicht durch gemeinsames Brennen eines hochschmelzenden Metalls mit dem Keramiksubstrat gebildet wird, wobei sich die Basismetallschicht durch die Öffnung erstreckt und auf der ersten Oberseite gebildet ist, wobei die Basismetallschicht eine zweite Oberseite und eine oder mehrere Seitenflächen umfasst, und wobei sich die zweite Oberseite zumindest teilweise über die erste Oberseite erstreckt,
eine edelmetallhaltige Schicht 308, die schützend auf die Basismetallschicht derart aufgebracht ist, dass die edelmetallhaltige Schicht die zweite Oberseite der Basismetallschicht bedeckt und zumindest teilweise die eine oder mehreren Seitenflächen der Basismetallschicht bedeckt, und
eine auf Gold (Au) basierende Schicht 312, die direkt auf der edelmetallhaltigen Schicht gebildet ist.

2. Keramikgehäuse nach Anspruch 1, wobei das hochschmelzende Metall Wolfram (W) und/oder Molybdän (Mo) umfasst.

3. Keramikgehäuse nach Anspruch 1, wobei die edelmetallhaltige Schicht Palladium (Pd) umfasst.

4. Keramikgehäuse nach Anspruch 1, wobei das Keramikgehäuse zwischen der Au-basierten Schicht und dem Keramiksubstrat kein Nickel (Ni) enthält.

5. Keramikgehäuse nach Anspruch 1, wobei die edelmetallhaltige Schicht die zumindest eine Öffnung zumindest teilweise ausfüllt.

6. Keramikgehäuse nach Anspruch 1, wobei zumindest ein Teil der Basismetallschicht in das Keramiksubstrat eingebettet ist.

7. Keramikgehäuse nach Anspruch 6, wobei sich die edelmetallhaltige Schicht vertikal durch eine gesamte Dicke des Keramiksubstrats erstreckt.

8. Keramikgehäuse nach Anspruch 1, wobei zumindest ein Teil der Basismetallschicht und das Keramiksubstrat eine koplanare Oberfläche bilden.

9. Keramikgehäuse nach Anspruch 1, wobei die edelmetallhaltige Schicht 4 Gew.-% oder weniger Phosphor (P) oder Bor (B) umfasst, oder wobei das Keramikgehäuse frei von P und/oder B ist.

10. Keramikgehäuse nach Anspruch 1, das ferner einen Deckel 410 umfasst, wobei das Keramiksubstrat einen Hohlraum 406 definiert, der dazu konfiguriert ist, die elektronische Vorrichtung aufzunehmen, wobei der Deckel dazu konfiguriert ist, die elektronische Vorrichtung in dem Hohlraum hermetisch abzudichten, und wobei der nichtmagnetische Metallisierungsstapel als Dichtungsmittel dient, das zwischen einem Rand des Hohlraums und dem Deckel angeordnet ist.

11. Keramikgehäuse nach Anspruch 1, wobei auf den gegenüberliegenden Oberflächen des Keramiksubstrats jeweils der nichtmagnetische Metallisierungsstapel ausgebildet ist, und wobei die nichtmagnetischen Metallisierungsstapel auf den gegenüberliegenden Oberflächen des Keramiksubstrats optional durch eine gemeinsame Basismetallschicht verbunden sind, die sich durch eine gesamte Dicke des Keramiksubstrats erstreckt.

## Revendications

1. Boîtier en céramique 100A, 100B configuré pour loger un dispositif électronique 108, le boîtier en céramique comprenant :
un substrat en céramique 104 intégré à une pile de métallisation non magnétique 130, où
le substrat en céramique comprend une première surface supérieure, une surface inférieure et au moins une ouverture 120, 132 s'étendant de la surface supérieure à la surface inférieure ; et
la pile de métallisation non magnétique comprenant :
une couche de métal de base 134 formée sur le substrat en céramique, où la couche de métal de base est formée par cuisson conjointe d'un métal réfractaire avec le substrat en céramique, où la couche de métal de base s'étend à travers l'ouverture et est formée sur la première surface supérieure, où la couche de métal de base comprend une deuxième surface supérieure et une ou plusieurs surfaces latérales, et où la deuxième surface supérieure s'étend au moins partiellement sur la première surface supérieure,
une couche contenant un métal noble 308 plaquée de manière conforme sur la couche de métal de base de telle sorte que la couche contenant un métal noble recouvre la deuxième surface supérieure de la couche de métal de base et recouvre au moins partiellement les une ou plusieurs surfaces latérales de la couche de métal de base, et
une couche à base d'or (Au) 312 formée directement sur la couche contenant un métal noble.

2. Boîtier en céramique selon la revendication 1, où le métal réfractaire comprend l'un ou les deux parmi le tungstène (W) et le molybdène (Mo).

3. Boîtier en céramique selon la revendication 1, où la couche contenant un métal noble comprend du palladium (Pd).

4. Boîtier en céramique selon la revendication 1, où le boîtier en céramique n'inclut pas de nickel (Ni) entre la couche à base d'Au et le substrat en céramique.

5. Boîtier en céramique selon la revendication 1, où la couche contenant un métal noble remplit au moins partiellement l'au moins une ouverture.

6. Boîtier en céramique selon la revendication 1, où au moins une partie de la couche de métal de base est noyée dans le substrat en céramique.

7. Boîtier en céramique selon la revendication 6, où la couche contenant un métal noble s'étend verticalement sur une épaisseur entière du substrat en céramique.

8. Boîtier en céramique selon la revendication 1, où au moins une partie de la couche de métal de base et le substrat en céramique forment une surface coplanaire.

9. Boîtier en céramique selon la revendication 1, où la couche contenant un métal noble comprend 4 % en poids ou moins de phosphore (P) ou de bore (B) ou bien où la couche contenant un métal noble est exempte d'un ou des deux parmi P et/ou B.

10. Boîtier en céramique selon la revendication 1, comprenant en outre un couvercle 410, où le substrat en céramique définit une cavité 406 configurée pour loger le dispositif électronique, où le couvercle est configuré pour sceller hermétiquement le dispositif électronique dans la cavité, et où la pile de métallisation non magnétique sert de joint d'étanchéité disposé entre un rebord de la cavité et le couvercle.

11. Boîtier en céramique selon la revendication 1, où chacune des surfaces opposées du substrat en céramique comporte, formée sur celle-ci, la pile de métallisation non magnétique, et où les piles de métallisation non magnétiques sur les surfaces opposées du substrat en céramique sont éventuellement connectées par une couche de métal de base commune s'étendant sur une épaisseur entière du substrat en céramique.
